# EUROPEAN PATENT APPLICATION

(11) **EP 1 571 753 A1**
(43) Date of publication of application: **07.09.2005**
(21) Application number: 05003880.1
(22) Date of filing: 23.02.2005
(51) Int. Cl.: H03G 9/02, H04R 3/04

(54) **Method and apparatus of compensating for speaker distortion in an audio apparatus**

(30) Priority: 04.03.2004 KR 2004014488
(71) Applicant: LG ELECTRONICS INC., Seoul 150-010 (KR)
(72) Inventor: Kwon, Oh Suk, Eunpyung-gu Seoul, 122-080 (KR)
(74) Representative: Vossius & Partner

(57) **Abstract**

Embodiments of methods and apparatus of compensating for speaker distortion in an audio apparatus can compensate for frequency components of an input audio signal that will be distorted by a nonflat frequency response of a speaker. The compensation can occur before the input audio signal is applied to the speaker. Thus, the frequency response of the cascaded system including a compensator and the speaker can be flatter than that of the speaker. Embodiments of the present invention can reduce or prevent distortion of an input audio signal distorted by the speaker (Fig. 1).

## Description

The present invention relates to a method and apparatus of compensating for speaker distortion in an audio apparatus.

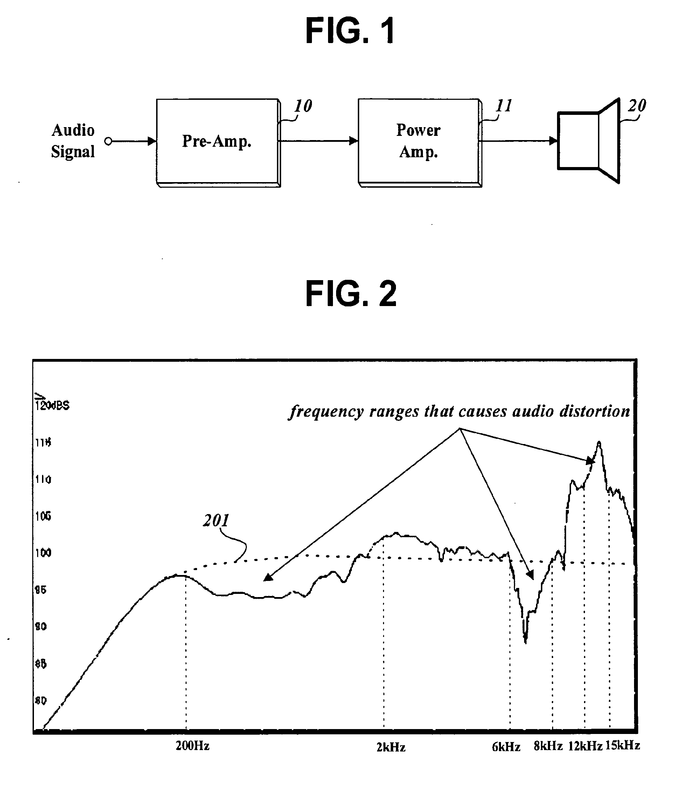

Various audio apparatuses that play recorded audio data with high-quality/high-power amplification are commercially available on the market. FIG. 1 illustrates a block diagram of an audio signal processing system of a conventional audio apparatus. As shown in Fig. 1 the system has a pre-amp 10, a power amp 11, and a speaker 20.

The pre-amp 10 takes a low-level audio signal from an input and alters its amplitude. The pre-amp 10 prepares the signal for the power amp 11. Receiving the preamplified audio signal, the power amp 11 generates high-power audio signal needed to drive the speaker 20.

It is desirable that a speaker should have a flat frequency response (equal amplification of all audio frequencies) over the entire audible frequency range from 20 Hz to 20 kHz. However, it is extremely difficult to obtain such a flat frequency response, and the frequency response changes depending on the manufacturer or the model of the speaker 20.

In the case of FIG. 1, even though the pre-amp and power amp have a very desirable frequency response, the sound reproduced by the speaker will be distorted to some extent because of the imperfect frequency response of the speaker. For example, if the speaker 20 has a frequency response as shown in FIG. 2 in which the frequency response is not flat especially in the mid-frequency range of 200 Hz-2 KHz and the high-frequency ranges of 6-8 KHz and 12-15 KHz, the speaker 20 cannot provide high-fidelity sound.

The above references are incorporated by reference herein where appropriate for appropriate teachings of additional or alternative details, features and/or technical background.

An object of the invention is to solve at least the above problems and/or disadvantages or to provide at least the advantages described hereinafter.

Another object of the present invention is to provide a method and an apparatus capable of a frequency response that can compensate for speaker distortion.

Another object of the present invention is to provide a method and apparatus capable of compensating for speaker distortion by pre-modifying input audio signals in consideration of the nonflat frequency response of the speaker.

In order to achieve at least the above objects or advantages in a whole or in part, in accordance with one aspect of the present invention there is provided an apparatus including a speaker that includes a compensator device having a frequency band dependent gain configured to compensate for a frequency response of the speaker, wherein the frequency band dependent gain amplifies or attenuates frequency components of an input audio signal depending on the frequency band to which the frequency component belongs and a power amplifier configured to amplify a power of an audio signal provided by the compensator device to drive the speaker.

To further achieve at least the above objects or advantages in a whole or in part, in accordance with one aspect of the present invention there is provided an apparatus that includes a speaker having a corresponding frequency response, a power amplifier configured to amplify the power of an audio signal provided to drive the speaker and a compensator having a frequency band dependent response configured to make an effect on an audio signal output by the speaker closer to a prescribed frequency response than the frequency response of the speaker alone.

To further achieve at least the above objects or advantages in a whole or in part, in accordance with one aspect of the present invention there is provided an audio signal processing method that includes amplifying or attenuating a plurality of frequency components of an input audio signal according to a frequency band dependent gain set for compensating a frequency response of an audio output device and outputting the modified input audio signal obtained by said amplifying or attenuating the frequency components of the input audio signal.

Additional advantages, objects, and features of the invention will be set forth in part in the description which follows and in part will become apparent to those having ordinary skill in the art upon examination of the following or may be learned from practice of the invention. The objects and advantages of the invention may be realized and attained as particularly pointed out in the appended claims.

### BRIEF DESCRIPTION OF THE DRAWINGS

The invention will be described in detail with reference to the following drawings in which like reference numerals refer to like elements wherein:

FIG. 1 illustrates a block diagram of an audio signal processing system of a conventional audio apparatus;

FIG. 2 illustrates a frequency response graph of a conventional speaker;

FIG. 3 illustrates a block diagram showing an audio signal processing system in accordance with a preferred embodiment of the present invention;

FIG. 4 illustrates a block diagram showing an exemplary system for adjusting frequency response thereof to compensate for speaker distortion;

FIG. 5 illustrates a frequency response graph including a speaker distortion compensator and a speaker in accordance with a preferred embodiment of the present invention;

FIG. 6 illustrates a block diagram of an audio signal processing system in accordance with another preferred embodiment of the present invention; and

FIG. 7 illustrates an exemplary data structure of compensation data for a plurality of speakers.

### DETAILED DESCRIPTION OF PREFERRED EMBODIMENTS

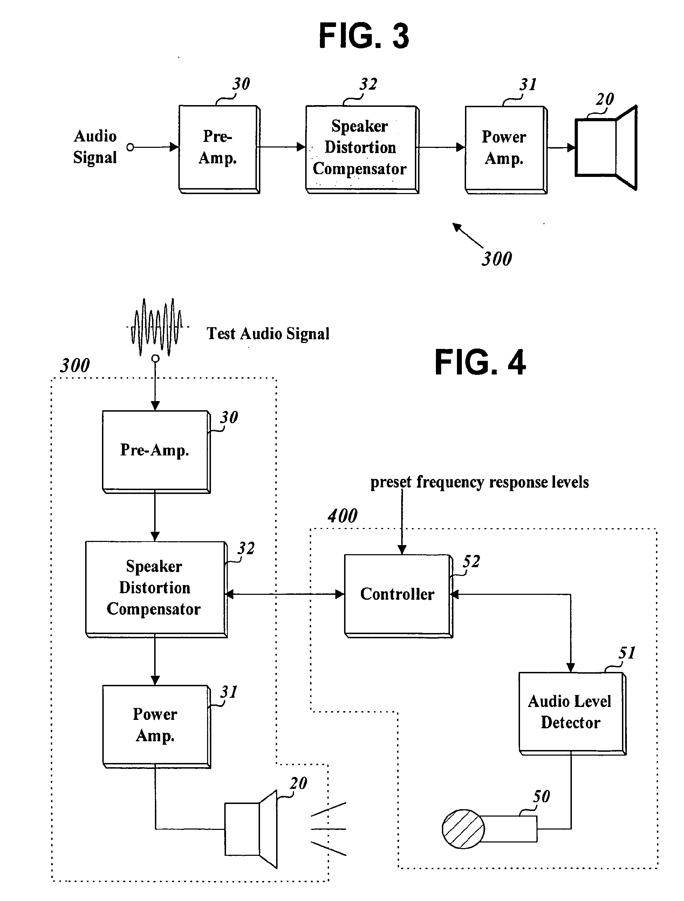

Embodiments of an apparatus and methods of compensating for speaker distortion in accordance with the present invention can be applied to various audio apparatuses having speakers. FIG. 3 illustrates a block diagram of an embodiment of an audio signal processing system of an audio apparatus embodying the present invention. As shown in Fig. 3, an audio signal processing system 300 can include a pre-amp 30, a power amp 31, a speaker 20, and a speaker distortion compensator 32.

The frequency response of the speaker distortion compensator 32 can be adjusted depending on the frequency response of the speaker 20. For example, the gain of the speaker distortion compensator 32 at each frequency band divided from an audible frequency range can be determined. Experiments using a measurement apparatus (e.g., apparatus 400) that measures the frequency response, can determine the gain of the speaker distortion compensator at each frequency band.

As shown in FIG. 4, an exemplary measurement apparatus 400 can include a microphone 50, an audio level detector 51, and a controller 52. The gain of the speaker distortion compensator 32 at each frequency band can be set by the controller 52, which will be described below.

Initially, the gain of the speaker distortion compensator 32 at every frequency band can be set to 0 dB. A test sound signal having frequency components belonging to a each of a plurality of frequency bands can be applied to the pre-amp 30. The test sound signal may be generated by a conventional signal generator. Sound corresponding to the test sound signal can be reproduced by the speaker 20 through the pre-amp 30, the speaker distortion compensator 32, and the power amp 31.

The sound reproduced by the speaker 20 is converted into an electrical signal by the microphone 50 of the measurement apparatus 400, and then the level of the electrical signal can be detected by the audio level detector 51. The controller 52 can compare the detected audio level with a preset reference level (e.g., corresponding to the test sound signal) and adjust the gain of the speaker distortion compensator 32 at the frequency band so that the detected sound level is closer to or preferably equals the reference level. The same operation can be performed at a subset of or all the other frequency bands.

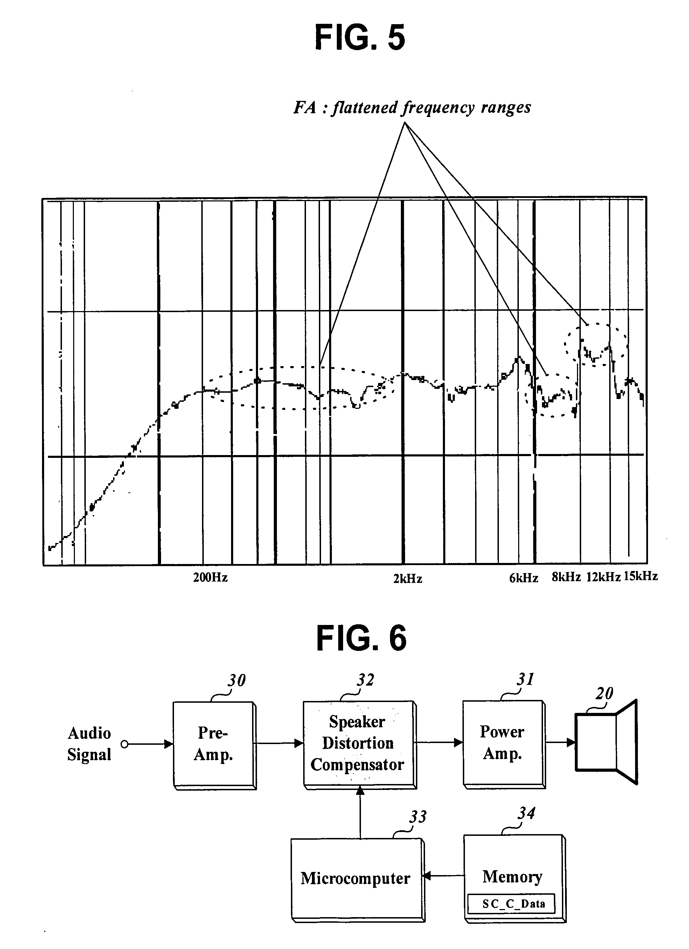

After the gain of the speaker distortion compensator 32 is adjusted (e.g., at every frequency band), the overall frequency response of the speaker distortion compensator 32 and the speaker 20 becomes flatter (e.g., frequency zones marked 'FA', 200Hz~2kHz, 6kHz~8kHz, 12kHz~15kHz) as shown in FIG. 5 compared to the frequency response shown in FIG. 2. This is because frequency components that are relatively attenuated by the speaker 20 can be amplified and frequency components that are relatively amplified by the speaker 20 can be attenuated by the speaker distortion compensator 32. Different frequency bands or components can be independently amplified attenuated by the speaker distortion compensator 32.

The speaker distortion compensator 32 can be implemented in various apparatus such as a portable computer or a home theater system. However, the present invention is not intended to be so limited.

FIG. 6 illustrates another embodiment of an audio apparatus according to the present invention. Unlike the embodiment of FIG. 3 wherein the gain of the speaker distortion compensator 32 at each frequency band can be directly set, for example, by the exemplary external measurement apparatus 400, in the embodiment of FIG. 6 the gain of the speaker distortion compensator 32 at each frequency band can be pre-stored, which is, the gain of the speaker distortion compensator 32 can be stored as compensation data (e.g., SC_C_Data) in a non-volatile memory 34 such as an EEPROM included in the audio apparatus. For example, the data or the gain of the speaker distortion compensator 32 for a plurality of frequency bands can be provided by a manufacturer according to model of a speaker or system or can be determined by the controller 52 of the measurement apparatus 400.

The compensation data (e.g., SC_C_Data) can be registered as the gain of the speaker distortion compensator 32 at each frequency band by a microcomputer 33 at an initial operation of the audio apparatus such as power-up reset. However, the present invention is not intended to be so limited.

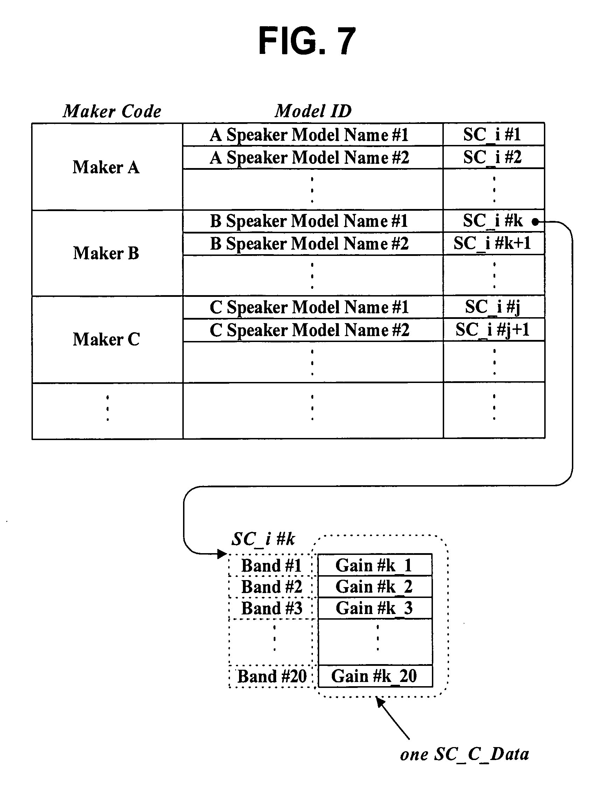

The experiment shown in FIG. 4 may be repeated for various speakers, (e.g., by type, model, manufacturer, etc.) and the obtained set of compensation data may be stored in the memory 34. For example, compensation data can be stored as a data structure as shown in FIG. 7, wherein the entire audible frequency range from 20 Hz to 20 kHz is divided into 20 frequency bands.

Compensation data for each speaker is preferably referenced by the maker code and model number thereof. If a user enters a maker code and model number into the audio apparatus shown in FIG. 6, the microcomputer 33 can retrieve the compensation data corresponding to the maker code and model number from the memory 34 and set the gain of the speaker distortion compensator 32 accordingly. If the requested compensation data does not exist in the memory 34, the microcomputer 33 can set the gain of the speaker distortion compensator 32 to 0 dB, which can prevent the speaker distortion compensator 32 from distorting input audio signal. However, the present invention is not intended to be so limited.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments. Furthermore, for ease of understanding, certain method procedures may have been delineated as separate procedures; however, these separately delineated procedures should not be construed as necessarily order dependent in their performance. That is, some procedures may be able to be performed in an alternative ordering, simultaneously, etc.

As described above, embodiments of the method and apparatus for compensating speaker distortion according to the present inventions have various advantages. For example, embodiments of a method and apparatus of compensating speaker distortion in accordance with the present invention can compensate for speaker distortion caused by a nonflat frequency response of a speaker (e.g., in advance) by adjusting the frequency response of a distortion compensator. In one embodiment, the speaker distortion is measured then a compensator is correspondingly adjusted. In one embodiment, the frequency band dependent gain of the speaker distortion compensator can be stored in a memory and retrieved from the memory at an initial operation of the audio apparatus by a controller. Accordingly, embodiments can provide high-fidelity sound despite speaker distortion.

The foregoing embodiments and advantages are merely exemplary and are not to be construed as limiting the present invention. The present teaching can be readily applied to other types of apparatuses. The description of the present invention is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

## Claims

1. An apparatus including a speaker, comprising:
a compensator device having a frequency band dependent gain configured to compensate for a frequency response of the speaker, wherein the frequency band dependent gain amplifies or attenuates frequency components of an input audio signal depending on the frequency band to which the frequency component belongs; and
a power amplifier configured to amplify a power of an audio signal provided by the compensator device to drive the speaker.

2. The apparatus of claim 1, further comprising a controller configured to set the frequency band dependent gain of the compensator device.

3. The apparatus of claim 2, wherein the frequency band dependent gain of the compensator device is 0 dB before the frequency band dependent gain is set by the controller.

4. The apparatus of claim 2 or 3, further comprising a storage medium coupled to the controller and configured to store the frequency band dependent gain used by the controller to set the compensator device.

5. The apparatus of claim 4, wherein the storage medium stores a plurality of frequency band dependent gains for a corresponding plurality of speakers having distinct frequency responses.

6. The apparatus of claim 5, wherein the controller selects a prescribed frequency band dependent gain specified by an external input as corresponding to the speaker from among the plurality of frequency band dependent gains and sets the frequency band dependent gain of the compensator device to the prescribed frequency band dependent gain.

7. The apparatus of any of claims 1 to 6, wherein the frequency band dependent gain of the compensator device is configured to make a frequency response of the cascaded system comprising the compensator and the speaker flatter than the frequency response of the speaker.

8. The apparatus of any of claims 1 to 7, further comprising a pre-amplifier for boosting the input audio signal to a predefined level and providing the boosted input audio signal to the compensator, wherein the frequency band dependent gain is determined by measuring a test audio signal output by the speaker, and wherein the apparatus is a portable computer.

9. An apparatus, comprising:
a speaker having a corresponding frequency response;
a power amplifier configured to amplify the power of an audio signal provided to drive the speaker; and
a compensator having a frequency band dependent response configured to make an effect on an audio signal output by the speaker closer to a prescribed frequency response than the frequency response of the speaker alone.

10. The apparatus of claim 9, wherein the prescribed frequency response is a substantially equal amplification over all frequencies in a frequency range from 200Hz to 20kHz.

11. The apparatus of claim 9 or 10, wherein the effect on the audio signal output by the speaker is to amplify or attenuate each frequency component of an input audio signal.

12. The apparatus of any of claims 9 to 11, wherein said effect on the audio signal output by the speaker is to flatten the frequency response of the speaker.

13. The apparatus of claim 12, wherein said effect is a cascaded frequency response of the apparatus, and wherein the apparatus is for a personal computer.

14. An audio signal processing method, comprising:
amplifying or attenuating a plurality of frequency components of an input audio signal according to a frequency band dependent gain set for compensating a frequency response of an audio output device; and
outputting the modified input audio signal obtained by said amplifying or attenuating the frequency components of the input audio signal.

15. The method of claim 14, wherein the input audio signal is a signal preamplified to a prescribed level, and wherein the modified input audio signal is output to a speaker after power amplification.

16. The method of claim 14 or 15, wherein the frequency band dependent gain, which corresponds to a speaker being the output device, is selected from among a plurality of pre-stored frequency band dependent gains.

17. The method of any of claims 14 to 16, wherein the frequency band dependent gain is intended for amplifying or attenuating frequency components belonging to frequency range where frequency response of the output device is not flat.

18. The method of claim 14, comprising selecting the frequency band dependent gain, wherein the selecting comprises:
providing a speaker distortion compensator in an audio system including a speaker;
detecting a type of speaker in the audio system; and
selecting one frequency band dependent gain for the speaker distortion compensator corresponding to the detected speaker from among a plurality of frequency band dependent gains stored in a memory of the audio system as the frequency band dependent gain;
adjusting the frequency response of the speaker distortion compensator responsive to the selected frequency band dependent gain.

19. The method of claim 18, wherein the speaker type is detected during assembly of the audio system or during manufacture of the audio system.

20. The method of claim 18, wherein the selecting one frequency band dependent gain comprises:
setting a frequency band dependent gain of the speaker distortion compensator to 0 dB across a prescribed frequency range;
inputting first audio signal to the audio system;
measuring an output of the first audio signal from the speaker to determine the characteristic data;
storing an associated frequency band dependent gain determined according to the characteristic speaker data in the memory; and
repeating the setting through storing steps for a plurality of speakers.
